# EUROPEAN PATENT SPECIFICATION

(11) **EP 2 909 892 B1**
(45) Date of publication and mention of the grant of the patent: **05.12.2018**
(21) Application number: 13779142.2
(22) Date of filing: 17.10.2013
(51) Int. Cl.: H01R 4/66, H03G 3/06, G01R 1/04, G01R 3/00, G01R 15/14, H01R 13/652

(54) **MANUFACTURING PROCESS FOR A VOLTAGE AND/OR CURRENT SENSOR IN A CASTED MEASUREMENT DEVICE, AND SENSOR ITSELF**
VERFAHREN ZUR HERSTELLUNG EINES SPANNUNGS- UND/ODER STROMS-SENSOR IN EINEM GEGOSSENEN GEHÄUSE EINER MESSVORRICHTUNG, UND ENTSPRECHENDER SENSOR
PROCÉDÉ DE FABRICATION D'UN CAPTEUR DE TENSION ET/OU COURANT DANS UN CHASSIS MOULÉ D'UN DISPOSITIF DE MESURE, ET CAPTEUR CORRESPONDANT

(30) Priority: 18.10.2012 EP 12007205
(43) Date of publication of application: 26.08.2015
(73) Proprietor: ABB Schweiz AG, 5400 Baden (CH)
(72) Inventor: RASCHKA, David, Greenville /NC (US); PODZEMNY, Jaromir, 621 00 Brno (CZ); VELESIK, Petr, 602 00 Brno (CZ)
(74) Representative: Schmidt, Karl Michael
(86) International application number: PCT/EP2013/003126
(87) International publication number: WO 2014/060105

(56) References cited:
- US-A- 4 210 374
- US-A1- 2006 237 210
- US-B1- 6 238 222

## Description

The invention relates to a Manufacturing process for a measurement device with a voltage and/or a current sensor in a casted measurement device housing, wherein the sensor component is connected with a externally ending output connector by a signal wire, and with a grounding wire to a grounding output connector, where signal connector output and grounding connector output results as the electrical connecting terminal, and measuring device itself, according to the preamble of claim 1 and 2. The traditional approach of a measurement device connector holder relies on a special fixation component to ensure the connector placement in the defined position during manufacturing process. Such special fixation component is a part of the casting mould or it is removeable after manufacturing process. In both cases it has no job within the measurement device functionality after the manufacturing process.

From the measurement device grounding system point of view, the appropriate interconnection between active internal parts point(s) which must be grounded and the earth potential is performed by a separate conductor connected to a sensing component on the one side and, on the opposite side, for example to an additional metal insert which is afterwards grounded. US 6 238 222 B1 discloses a grounding device for an electrical connector. An interconnecting port is used, to connect to ground potential. US 2006/237210 A1 discloses a ground wire connector, which is arranged circumferentially to a locking nut arrangement. US 4 210 374 A discloses a screw bushing with an integrated electrical clamp for grounding. It is an object of the invention to ensure an accurate positioning of the voltage and/or current measurement device during the moulding process, as well as a sure mechanical and electrical fixation of the connecting terminal at the ready measurement device.

So this is solved by the features of the invention, which are, that a further mechanical element (8) is arranged at the electrical connecting terminal, and provided with a central hole (10), through which the signal connector output is feeded, and at least one further connecting finger (8'), which is used as electrical grounding connection as well as a mechanical fixation of the electrical connecting terminal during the moulding process. The invention is defined by the independent claims 1 and 2; additional features are defined by the corresponding dependent claims.

So, during the moulding process, the invention related mechanical element ensures an accurate positioning of the connecting signal terminal. Additionally to that this element has the implemented function of a grounding connector holder as well.

So in order to combine measurement device connector fixation function during manufacturing process and a conductive connection function within the measurement device grounding system during the period when the measurement device is in use, it is proposed to integrate these requirements in a common solution.

This differs from the state of the art, in which mechanical fixation and electrical grounding connection will be handeld by separated elements.

In a further embodiment is proposed, that the mechanical element is provided with a central plate, where the central hole is arranged, and with at least one finger element aligned away from the central plate. So the signal output connector is positioned very accurate during the moulding process.

In a further advantageous embodiment at least three finger element are arranged circular and equidistant to each other around the central plate and the central hole.

In a further advantageous embodiment each of the fingers are provided with holes near the end of each fingers.

In a further advantageous embodiment is proposed, that the central hole has a section which differs from a circular circumferential inner line, in that way, that the mechanical/connecting element is provided with that with an antitwist protection relative to connector.

In a further advantageous embodiment, the further mechanical element 8 is a lost part, which is connected to a voltage and/or current sensor housing, in order to center the resistor and other sensor parts inside this housing. Lost part means, that it is for centering the signal connector in the sensor housing. After mounting, the housing will be filled with a resin material, so that this "lost part" will be implemented into that resin.

Therefore, an advantageous embodiment is, that the housing of the voltage and/or current sensor is made of an insulating material. This "separate" housing can give the enclosure for a further resin.

In an advantageous embodiment, the resin material is the same material like the material of the housing. That means, both material could be epoxy.

Alternativley the filling resin material can be different from the material of the housing. So the housing could be made of thermoplastic material and the filling can be realized by a self activating resin epoxy component mixture, which will be thermally activated by completing the mixture during the filling procedure into the housing.

As a final advantageous embodiment, the housing of the voltage and/or current sensor is covered at the side, where the grounding connector holder (8) is placed, by a cap, with a central opening, though which the signal input and/or output connector is guided though, to external connection.

The invention is shown in the drawing and described as follows.

In order to combine measurement device connector fixation function during manufacturing process and a conductive connection function within the measurement device grounding system during the period when the measurement device is in use, it is proposed to integrate these requirements separate solutions, into a single component solution.

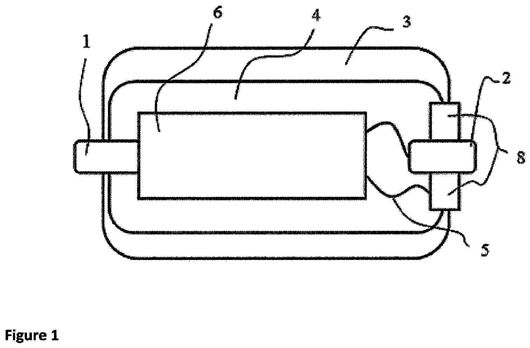

Such component 8 will be fixed to the measurement device body 4 and/or to any internal current and/or voltage sensing part 6 and/or to a mould 3 in one or more points on the one side and to the measurement device input and/or output connector 2 in one or more points on the oposite side. Conductive coupling between the connector holder 8 and the current and/or voltage sensing part 6 will be solved either as the direct connection by a conductor 5, see Fig. 1, or by a dedicated section of the grounding connector holder 8 connected to the voltage and/or current sensing element 6, or as an indirect connection when connector holder 8 will be conductively coupled with the connector 2 which will be conductively coupled with the sensing part 6.

Material of the component 8 must be selected in such a way to ensure the providing both mechanical stability of the measurement device connector 2 placement during manufacturing process and during the measurement device 4 operational time - mechanical deformation of any section of the connector holder 8 due to a mechanical load as a result of the holder 8 fixation and the connector 2 weight must be less than 10mm in any axes direction - and electrical properties to ensure sufficient electrical charge transfer within its functionality as a part of the
measurement device grounding system.

The advantage of the proposed solution is the combination of mechanical and electrical functionality within one single part, what means less complete assembly components, easirer manufacturing process, reduced manufacturing time and reduced production costs of the final measurement device.

Additional advantage of the proposed solution is the reinforcing effect of the grounding holder 8 of the connector 2 to the measurement device body 4 structure.

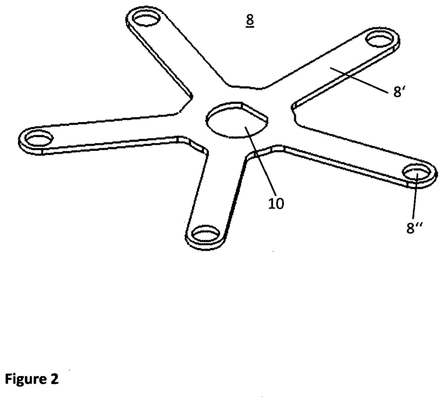

Figure 2 shows the grounding connector holder 8 in detail. This embodiment of the groud connector holder 8 shows the central hole 10, through is feeded the signal connectors 2 shown in figure 1. Furthermore is shown in figure 2, that this hole is not perfect round, but has a section which differs from a perfect round inner line, in order to correspond mechanically with a complementive outer surface of the connector in such a way, that with this is implemented an antitwist element.

Furthermore the grounding connector holder 8 has five fingerelements 8' whoich are arrangned circular around the inner plate section of the holder 8. These fingers has holes 8" at each their ends for mechanical and/or electrical connection to ground potential.

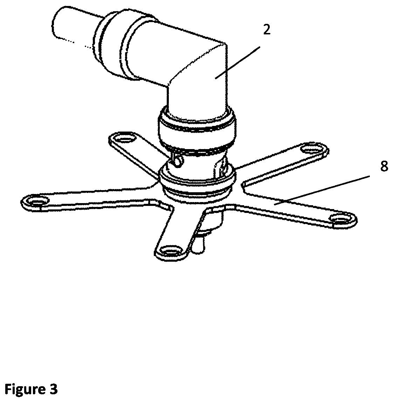

Figure 3 shows the grounding connector 8 in connection with the signal connector 2.

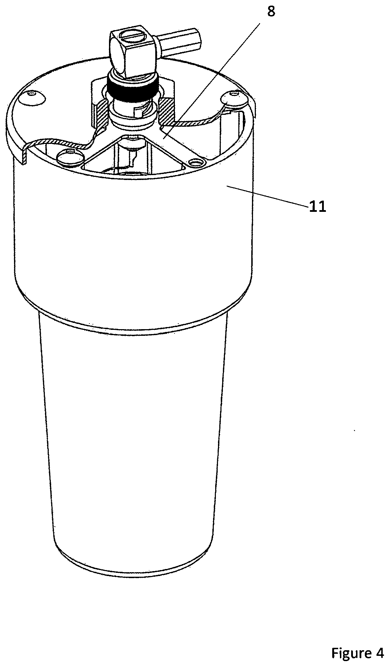

Figure 4 shows a perspective view, where the grounding connector 8 with the signal connector 2 is fixed with screws in a voltage and/or current sensor housing.

So the grounding signal connector 8 also centers inside the housing 11 the resistor arrangement of the sensor. After positioning the signal connector and the resistor, and other sensor parts inside the housing 11, the housing can be filled with a mixture of component resin material like expoxy, wherein the resin mixture is thermally activated by chemical reaction of the mixture. So the centering signal connector is finally implemented in that filling resin material as a lost part finally.

### Position numbers

- 1: Fixation component
- 2: Signal input and/or output connector
- 3: Mould
- 4: Measurement device body
- 5: Conductor
- 6: Sensing part/sensor
8 grounding connector holder
8' finger element
8" hole in finger element
10 central hole
11 housing of the voltage and/or current sensor

## Claims

1. Manufacturing process for a measurement device with a voltage and/or a current sensor in a casted measurement device housing, wherein the sensor component is connected with a externally ending output connector by a signal wire, and with a grounding wire to a grounding output connector, where signal connector output and grounding connector output results as the electrical connecting terminal, the manufacturing process comprising the steps of:
arranging a further mechanical element (8) at the electrical connecting terminal, wherein the further mechanical element (8) is provided with a central hole (10), through which the signal connector output is feeded;
carrying out a moulding process; and
filling the housing with a mixture of component resin material which is thermally activated by chemical reaction of the mixture;
the manufacturing process being **characterised in that** the further mechanical element (8) comprises at least one further connecting finger (8'), that is used as electrical grounding connection as well as a mechanical fixation of the electrical connecting terminal during the aforesaid moulding process, wherein the further mechanical element (8) is a lost part, which is connected to the voltage and/or current sensor housing, in order to center the sensor inside the casted measurement device housing.

2. Measurement device with a voltage and/or a current sensor in a casted measurement device housing, wherein the sensor component is connected to a signal connector output by a signal wire, and to a grounding connector output by a grounding wire, and that the signal connector output and grounding connector output form an electrical connecting terminal, wherein the measurement device is manufactured by the process according to claim 1, and a further mechanical element (8) is arranged at the electrical connecting terminal, and provided with a central hole (10), through which the signal connector output is feeded, **characterized in that** the further mechanical element (8) comprises at least one connecting finger (8'), that is used as electrical grounding connection as well as a mechanical fixation of the electrical connecting terminal during the moulding process, the further mechanical element (8) is a lost part, which is connected to the voltage and/or current sensor housing, in order to center the sensor inside the casted measurement device housing.

3. Measurement device according to claim 2, wherein the mechanical element (8) is provided with a central plate, where the central hole is arranged, and with the at least one connecting finger element (8') aligned away from the central plate.

4. Measurement device according to claim 2 or 3, wherein the at least one connecting finger element (8') consists of at least three finger element (8') that are arranged circular and equidistant to each other around the central plate and the central hole (10).

5. Measurement device according to claim 2, 3, or 4 wherein each of the at least one connecting finger (8') is provided with holes (8") near the end of each finger (8').

6. Measurement device according to one of the aforesaid claims 2-5, wherein the central hole has a section which differs from a circular circumferential inner line, in that way, that the mechanical/connecting element (8) is provided with that with an anti-twist protection relative to connector (2).

7. Measurement device according to claim 6, wherein the housing of the voltage and/or current sensor is made of an insulating material.

8. Measurement device according to claim 6, wherein the housing of the voltage and/or current sensor is filled with a component, that is the same material as the resin material of the casted measurement device housing.

9. Measurement device according to claim 6, wherein the mixture of component resin material is different from the material of the the casted measurement device housing.

10. Measurement device according to one of the aforesaid claims 2-9, wherein the housing of the voltage and/or current sensor is covered at the side, where the grounding connector holder (8) is placed, by a cap, with a central opening, though which the signal input and/or output connector is guided though, to external connection.

## Patentansprüche

1. Herstellungsverfahren für eine Messvorrichtung mit einem Spannungs- und/oder einem Stromsensor in einem gegossenen Gehäuse der Messvorrichtung, wobei die Sensorkomponente mit einem extern endenden Ausgangsverbinder durch einen Signaldraht verbunden und mit einem Erdungsdraht an einen Erdungsausgangsverbinder angeschlossen ist, wo ein Signalverbinderausgang und ein Erdungsverbinderausgang den elektrischen Verbindungsanschluss ergeben, wobei das Herstellungsverfahren die Schritte umfasst:
Anordnen eines weiteren mechanischen Elements (8) an dem elektrischen Verbindungsanschluss, wobei das weitere mechanische Element (8) mit einem mittigen Loch (10) versehen ist, durch welches der Signalverbinderausgang gespeist wird;
Durchführen eines Gussvorgangs; und
Verfüllen des Gehäuses mit einer Mischung aus Komponentenharzmaterial, das durch eine chemische Reaktion der Mischung thermisch aktiviert wird;
wobei das Herstellungsverfahren **dadurch gekennzeichnet ist, dass** das weitere mechanische Element (8) mindestens einen weiteren Verbindungsfinger (8') umfasst, der als elektrische Erdungsverbindung sowie als mechanische Fixierung des elektrischen Verbindungsanschlusses während des Gussvorgangs benutzt wird, wobei das weitere mechanische Element (8) ein verlorenes Teil ist, das an das Spannungs- und/oder Stromsensorgehäuse angeschlossen ist, um den Sensor im Inneren des gegossenen Gehäuses der Messvorrichtung zu zentrieren.

2. Messvorrichtung mit einem Spannungs- und/oder einem Stromsensor in einem gegossenen Gehäuse der Messvorrichtung, wobei die Sensorkomponente an einen Signalverbinderausgang durch einen Signaldraht angeschlossen und an einen Erdungsausgangsverbinder mit einem Erdungsdraht angeschlossen ist, und dass der Signalverbinderausgang und der Erdungsverbinderausgang einen elektrischen Verbindungsanschluss bilden, wobei die Messvorrichtung nach dem Verfahren nach Anspruch 1 hergestellt ist,
und ein weiteres mechanisches Element (8) an dem elektrischen Verbindungsanschluss angeordnet ist und mit einem mittigen Loch (10) versehen ist, durch welches der Signalverbinderausgang gespeist wird,
**dadurch gekennzeichnet, dass** das weitere mechanische Element (8) mindestens einen Verbindungsfinger (8') umfasst, der als elektrische Erdungsverbindung sowie als mechanische Fixierung des elektrischen Verbindungsanschlusses während des Gussvorgangs benutzt wird, wobei das weitere mechanische Element (8) ein verlorenes Teil ist, das an das Spannungs- und/oder Stromsensorgehäuse angeschlossen ist, um den Sensor im Inneren des gegossenen Gehäuses der Messvorrichtung zu zentrieren.

3. Messvorrichtung nach Anspruch 2, wobei das mechanische Element (8) mit einer mittigen Platte, in welcher das mittige Loch angeordnet ist, und mit dem mindestens einen Verbindungsfingerelement (8') versehen ist, das von der mittigen Platte weg angeordnet ist.

4. Messvorrichtung nach Anspruch 2 oder 3, wobei das mindestens eine Verbindungsfingerelement (8') aus mindestens drei Fingerelementen (8') besteht, die kreisförmig und äquidistant zueinander um die mittige Platte und das mittige Loch (10) herum angeordnet sind.

5. Messvorrichtung nach Anspruch 2, 3 oder 4, wobei jeder von dem mindestens einen Verbindungsfinger (8') mit Löchern (8'') nahe dem Ende des jeweiligen Fingers (8') versehen ist.

6. Messvorrichtung nach einem der Ansprüche 2 bis 5, wobei das mittige Loch eine Sektion aufweist, die sich von einer kreisförmigen inneren Umfangslinie derart unterscheidet, dass das mechanische/Verbindungselement (8) damit mit einem Verdrehungsschutz relativ zu dem Verbinder (2) versehen ist.

7. Messvorrichtung nach Anspruch 6, wobei das Gehäuse des Spannungs- und/oder Stromsensors aus einem isolierenden Material hergestellt ist.

8. Messvorrichtung nach Anspruch 6, wobei das Gehäuse des Spannungs- und/oder Stromsensors mit einer Komponente verfüllt ist, bei der es sich um das gleiche Material wie das Harzmaterial des gegossenen Gehäuses der Messvorrichtung handelt.

9. Messvorrichtung nach Anspruch 6, wobei die Mischung des Komponentenharzmaterials sich von dem Material des gegossenen Gehäuses der Messvorrichtung unterscheidet.

10. Messvorrichtung nach einem der Ansprüche 2 bis 9, wobei das Gehäuse des Spannungs- und/oder Stromsensors an der Seite, an welcher der Erdungsverbinderhalter (8) platziert ist, von einer Kappe mit einer mittigen Öffnung abgedeckt ist, durch welche der Signaleingangs- und/oder -ausgangsverbinder hindurchgeführt ist zu einer externen Verbindung.

## Revendications

1. Procédé de fabrication d'un dispositif de mesure ayant un capteur de tension et/ou de courant dans un boîtier de dispositif de mesure moulé, dans lequel le composant de capteur est raccordé à un connecteur de sortie se terminant de façon externe par un fil de signal, et à un fil de mise à la terre sur un connecteur de sortie de mise à la terre, où une sortie de connecteur de signal et une sortie de connecteur de mise à la terre a pour résultat la borne de connexion électrique, le procédé de fabrication comprenant les étapes consistant :
à disposer un élément mécanique supplémentaire (8) au niveau de la borne de connexion électrique, dans lequel l'élément mécanique supplémentaire (8) est pourvu d'un trou central (10) à travers lequel la sortie de connecteur de signal est alimentée ;
à mettre en oeuvre un processus de moulage ; et
à remplir le boîtier d'un mélange de matériau de résine de composant qui est thermo-activé par une réaction chimique du mélange ;
le procédé de fabrication étant **caractérisé en ce que** l'élément mécanique supplémentaire (8) comprend au moins un doigt de raccordement supplémentaire (8'), qui est utilisé comme connexion électrique de mise à la terre ainsi que comme fixation mécanique de la borne de connexion électrique durant le processus de moulage susmentionné, dans lequel l'élément mécanique supplémentaire (8) est une partie perdue, qui est raccordée au boîtier de capteur de tension et/ou de courant afin de centrer le capteur à l'intérieur du boîtier de dispositif de mesure moulé.

2. Dispositif de mesure ayant un capteur de tension et/ou de courant dans un boîtier de dispositif de mesure moulé, dans lequel le composant de capteur est raccordé à une sortie de connecteur de signal au moyen d'un fil de signal et à une sortie de connecteur de mise à la terre au moyen d'un fil de mise à la terre, et que la sortie de connecteur de signal et la sortie de connecteur de mise à la terre forment une borne de connexion électrique, dans lequel le dispositif de mesure est fabriqué par le procédé selon la revendication 1, et un élément mécanique supplémentaire (8) est disposé au niveau de la borne de connexion électrique et pourvu d'un trou central (10) à travers lequel la sortie de connecteur de signal est alimentée, **caractérisé en ce que** l'élément mécanique supplémentaire (8) comprend au moins un doigt de raccordement (8'), qui est utilisé comme connexion électrique de mise à la terre ainsi que comme fixation mécanique de la borne de connexion électrique durant le processus de moulage, l'élément mécanique supplémentaire (8) est une partie perdue, qui est raccordée au boîtier de capteur de tension et/ou de courant afin de centrer le capteur à l'intérieur du boîtier de dispositif de mesure moulé.

3. Dispositif de mesure selon la revendication 2,
dans lequel l'élément mécanique (8) est pourvu d'une plaque centrale, où le trou central est agencé, et du ou des éléments de doigt de raccordement (8') alignés à distance de la plaque centrale.

4. Dispositif de mesure selon la revendication 2 ou 3, dans lequel le ou les éléments de doigt de raccordement (8') se composent d'au moins trois éléments de doigt (8') qui sont disposés de manière circulaire et équidistante les uns par rapport aux autres autour de la plaque centrale et du trou central (10).

5. Dispositif de mesure selon la revendication 2, 3 ou 4,
dans lequel le doigt de raccordement ou chacun des doigts de raccordement (8') est pourvu de trous (8") près de l'extrémité de chaque doigt (8').

6. Dispositif de mesure selon l'une des revendications 2 à 5 susmentionnées,
dans lequel le trou central comporte une section qui est différente d'une ligne interne circonférentielle circulaire de telle manière que l'élément mécanique/de raccordement (8) soit pourvu de cette dernière avec une protection anti-torsion par rapport au connecteur (2).

7. Dispositif de mesure selon la revendication 6,
dans lequel le boîtier du capteur de tension et/ou de courant est réalisé en un matériau isolant.

8. Dispositif de mesure selon la revendication 6,
dans lequel le boîtier du capteur de tension et/ou de courant est rempli d'un composant qui est le même matériau que le matériau de résine du boîtier de dispositif de mesure moulé.

9. Dispositif de mesure selon la revendication 6,
dans lequel le mélange de matériau de résine de composant est différent du matériau du boîtier de dispositif de mesure moulé.

10. Dispositif de mesure selon l'une des revendications 2 à 9 susmentionnées,
dans lequel le boîtier du capteur de tension et/ou de courant est recouvert sur le côté, où le support de connecteur de mise à la terre (8) est placé, au moyen d'un capuchon, avec une ouverture centrale, à travers laquelle le connecteur d'entrée et/ou de sortie de signal est guidé, pour un raccordement externe.
